# EUROPEAN PATENT SPECIFICATION

(11) **EP 1 998 217 B1**
(45) Date of publication and mention of the grant of the patent: **17.09.2014**
(21) Application number: 08155825.6
(22) Date of filing: 07.05.2008
(51) Int. Cl.: G02F 1/1345, H05K 1/14, H05K 3/00

(54) **Liquid crystal module**
Flüssigkristallmodul
Module à cristaux liquides

(30) Priority: 30.05.2007 JP 2007142876
(43) Date of publication of application: 03.12.2008
(73) Proprietor: Funai Electric Co., Ltd., Daito-shi Osaka 574-0013 (JP)
(72) Inventor: Hayashi, Yuichi, Daito-shi, Osaka 574-0013 (JP)
(74) Representative: Beetz & Partner

(56) References cited:
- US-A1- 2002 186 333
- US-A1- 2005 068 486

## Description

### Field of the Invention

The present invention relates to a liquid crystal module which is used as a display device of an electronic equipment, for example, such as a television receiver, a micro computer, or the like, in particular, the present invention relates to technology to prevent damage of a flexible circuit board which is joined to outer peripheral portion of a liquid crystal cell.

### Description of Related Art

Recently, a display device utilizing a liquid crystal module has become popular as a display device of an electronic equipment such as a television receiver, a micro computer, or the like, because of merit of thin type, light weight, low power consumption, and the like. The liquid crystal module generally houses a back light source which is composed of a cold cathode tube and the like, and colored image is made be displayed on a display surface of a liquid crystal cell (which is called also a liquid crystal panel) by irradiating light emitted from the light source to the forward liquid crystal cell through an optical sheet such as a diffusion plate, a prism sheet, or the like, and passing the light through a color filter which is included in the liquid crystal cell.

The liquid crystal cell which is included in the liquid crystal module is structured to control operation of the liquid crystal cell by a signal, and various kind of driver elements and circuit boards are attached to the liquid crystal cell (See, for example, JP-A-2006-195225).

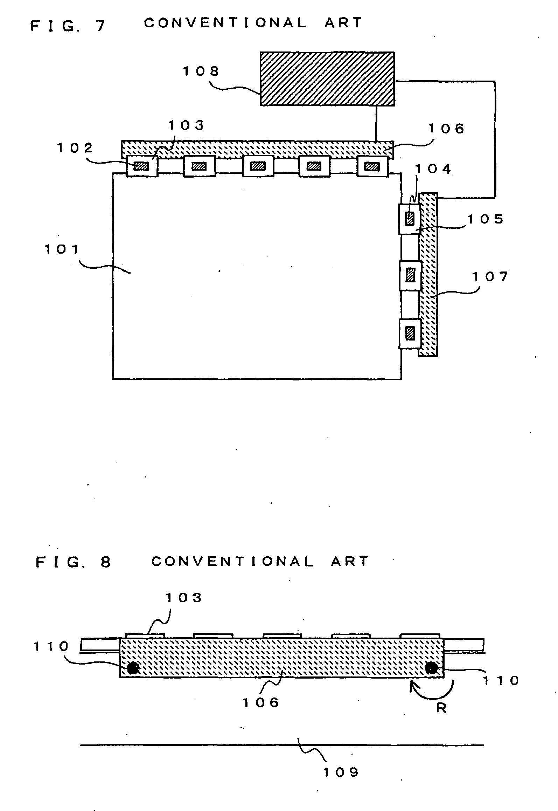

Fig. 7 is an explanatory diagram to explain relation between the conventional liquid crystal cell and each of a driver element and a circuit board which are attached to the liquid crystal cell. As shown in Fig. 7, a plurality of flexible circuit boards 103 and a plurality of flexible circuit boards 105 are joined to the conventional liquid crystal cell 101. Source drivers 102 to supply signal to a source of thin film transistor (TFT) which is set up on a glass substrate of the liquid crystal cell 101 and is not shown in the drawing are mounted on the flexible circuit boards 103 by chip on film (COF) method, for example. And gate drivers 104 to supply signal to a gate of the thin film transistor are mounted on the flexible circuit boards 105 by the COF method, for example.

The flexible circuit boards 103 on which the source drivers 102 are loaded, are directly joined to a source relay board 106. The source relay board 106 has a function to relay the flexible circuit boards 103 on which the source drivers 102 are loaded, and a controller board 108 on which a control circuit to control the source drivers 102 is loaded, and patterned lines to relay both boards are set up on it. Connection between the source relay board 106 and the controller board 108 is performed utilizing a connecting member which is composed of a flat cable and the like.

Further, the flexible circuit boards 105 on which the gate drivers 104 are loaded, are directly joined to a gate relay board 107. The gate relay board 107 has a function to relay the flexible circuit boards 105 on which the gate drivers 104 are loaded, and the controller board 108 on which a control circuit to control the gate drivers 104 is loaded. And patterned lines to relay both boards are set up on the gate relay board 107. Connection between the gate relay board 107 and the controller board 108 is performed utilizing a connecting member which is composed of a flat cable and the like.

It should be noted that the source relay board 106 and the gate relay board 107 are fixed by screw fastening on a rear frame which is not shown in the drawing and is disposed on a rear surface side (reverse side of the display surface) of the liquid crystal cell 101 in a state where the liquid crystal module is assembled.

In the conventional liquid crystal module that is structured as above described, a problem below described is caused when it is assembled. Fig. 8 is an explanatory diagram to explain the problem which is caused when the conventional liquid crystal module is assembled, and it shows a state when the source relay board 106 is fixed by screws 110 on the rear frame 109. In this example the source relay board 106 is structured such that both ends of it are fixed by screw fastening.

For example, if screw fastening is performed from right side in Fig. 8 firstly, force is applied on the source relay board 106 (force in a direction which is shown by arrow R in Fig. 8 is applied), when the fixing is performed. As a result, if the source relay board 106 is not fixed by some means, the source relay board 106 is rotated and it becomes a state where left side of it is raised. In such case, a load is applied to the flexible circuit boards 103 which are connected to the source relay board 106 and the liquid crystal cell 101 (See, Fig. 7), there happens a trouble that joining between the flexible circuit boards 103 and other member (the source relay board 106 or the liquid crystal cell 101) is come off or the flexible circuit boards 103 themselves are broken.

It should be noted that, if the screw fastening is performed from left side in Fig. 8 firstly, similarly, force is applied on the source relay board 106, and the source relay board 106 is moved (in this case it moves to lower side of Fig. 8), as a result, there happens a trouble of the damage of the flexible circuit boards 103 (coming off, break, or the like). Though in this example, explanation was given about the case where the source relay board 106 is fixed by the screw fastening, the problem of damage of the flexible circuit boards 105 is similarly caused on the gate relay board 107 because it is also fixed by the screw fastening.

As a result, heretofore when fixing by the screw is performed, the relay boards 106,107 are fixed temporarily on the rear frame 109 utilizing, for example, double stick tape or the like, and then the screw fastening is performed in order not to break the flexible circuit boards 103, 105 by rotation of the source relay board 106 and the gate relay board 107.

However, in the case where the relay boards 106, 107 are fixed temporarily on the rear frame 109 utilizing the double stick tape or the like and then the screw fastening is performed, there are problems, for example, assembling operation of the liquid crystal module becomes burdensome, and load for operation becomes large. Further, if the relay boards 106, 107 are disassembled because error in the assembling operation is found after they are fixed by screw, or for maintenance and the like, there is possibility that the flexible circuit boards 103, 105 are damaged because force is applied to them when the relay boards 106, 107 are removed from the rear frame 109, due to existence of the double stick tape which temporarily fixes the relay boards.

The document US 2005/0068486 A1 discloses a double-sided LCD device wherein two circuit boards are arranged on top of one another on the side face of a double-sided backlight unit. Bosses are provided to prevent interferences between the two circuit boards.

The document US 2002/0186333 A1 discloses a liquid crystal display device wherein a power supplying section and a signal converting section are disposed between the display section and a fixing section in order to minimize the thickness and weight of the device.

### SUMMARY OF THE INVENTION

In view of the above described problems it is an object of the present invention to provide a liquid crystal module which can reduce possibility of damage of a flexible circuit board which is joined to an outer peripheral portion of a liquid crystal cell when a liquid crystal module is assembled or disassembled. It is another object of the present invention to provide a liquid crystal module which can reduce possibility of damage of a flexible circuit board which is joined to an outer peripheral portion of a liquid crystal cell when a liquid crystal module is assembled or disassembled, and further reduces a load for assembling operation when the module is assembled.

To attain the above described object, a liquid crystal module in accordance with the present invention includes: a liquid crystal cell; a flexible circuit board which is joined to outer peripheral portion of the liquid crystal cell; a circuit board which is joined to the flexible circuit board; a frame portion on which the circuit board is fixed by screw fastening; at least one protruding portion which protrudes to the circuit board side with regard to a surface of the frame portion on which the circuit board is attached, and which prevents rotation of the circuit board along with rotation of the screw by contacting with the circuit board.

According to this structure, rotation of the circuit board along with rotation of the screw is prevented utilizing the protruding portion which protrudes to a side in that the circuit board is set up with regard to a frame portion surface in which the circuit board is attached. Because of this, rotation of the circuit board can be prevented without performing temporal fixing by the double stick tape or the like when the circuit board is fixed by the screw or the screw is removed. As a result, possibility that the flexible circuit board which is joined to the outer peripheral portion of the liquid crystal cell is damaged (coming off, break, or the like), can be reduced, and further, it becomes possible to reduce load for fixing operation by the screw.

Further in the present invention, the liquid crystal module as above described may further include a guide portion to perform positioning of the liquid crystal cell and the at least one protruding portion may be formed on at least one of the guide portion and the frame portion. According to this arrangement, structure to prevent rotation of the circuit board (rotation along with rotation of the screw) which is joined to a flexible circuit board can be realized by simple configuration.

Further in the present invention, it is preferable that the at least one protruding portion is formed integrally with the guide portion or the frame portion in the liquid crystal module structured as above described. According to this arrangement, structure to prevent rotation of the circuit board (rotation along with rotation of the screw) which is joined to the flexible circuit board can be realized without increasing number of parts, and it is advantageous in workability and in cost.

Further in the present invention, it is preferable that the at least one protruding portion comprises a plurality of protruding portions, and the plurality of protruding portions are set up such that they sandwich the circuit board in the liquid crystal module structured as above described. According to this arrangement, it becomes possible to more surely prevent rotation of the circuit board (rotation along with rotation of the screw) which is joined to the flexible circuit board.

Further, in the present invention, the plurality of protruding portions may be set up along both side surfaces of longer side or shorter side of the circuit board which is set up in substantially rectangular plate shape in the liquid crystal module structured as above described. According to this arrangement, it is easy to realize structure to prevent rotation of the circuit board (rotation along with rotation of the screw) which is joined to the flexible circuit board.

Further, in the present invention, a driver element to drive the liquid crystal cell may be loaded on the flexible circuit board, the liquid crystal module may further include a controller board on which a control circuit to control the driver element is loaded, and the circuit board may be a relay board to relay the flexible circuit board and the controller board in the liquid crystal module structured as above described.

As above described, according to the liquid crystal module in accordance with the present invention, the flexible circuit board which is joined to the outer peripheral portion of the liquid crystal cell can reduce possibility of damage when the liquid crystal module is assembled or disassembled, and workability when the liquid crystal module is assembled becomes better.

### BRIEF DESCRIPTION OF THE DRAWINGS

Fig. 1 is an exploded perspective view to show structure of a liquid crystal module according to a first embodiment;
Fig. 2A is an explanatory diagram to explain positional relation of a plurality of circuit boards which are set up to drive liquid crystal cells in the liquid crystal module according to the first embodiment, and is a schematic plan view when the liquid crystal module is viewed from a front side;
Fig. 2B is an explanatory diagram to explain positional relation of a plurality of circuit boards which are set up to drive liquid crystal cells in the liquid crystal module according to the first embodiment, and is a schematic plan view when the liquid crystal module is viewed from a reverse side;
Fig. 3 is a schematic cross sectional view when cut along III-III line in Fig. 2A;
Fig. 4 is a schematic plan view of a portion which is surrounded by dotted ellipse in Fig. 2A when viewed from position IV;
Fig. 5 is a schematic plan view of a liquid crystal module according to a second embodiment when viewed from a front side;
Fig. 6 is a schematic plan view of a portion which is surrounded by dotted ellipse in Fig. 5 when viewed from position VI;
Fig. 7 is an explanatory diagram to explain relation of a conventional liquid crystal cell and each of a driver element and a circuit board which are attached to the liquid crystal cell; and
Fig. 8 is a diagram to explain problem which is caused when the conventional liquid crystal module is assembled.

### DETAILED DESCRIPTION OF THE PREFERRED EMBODIMENTS

Hereinafter, explanation will be given about embodiments of a liquid crystal module in accordance with the present invention with reference to drawings. It should be noted that the embodiments shown here are mere examples and the present invention is not intended to be limited to the embodiments shown here.

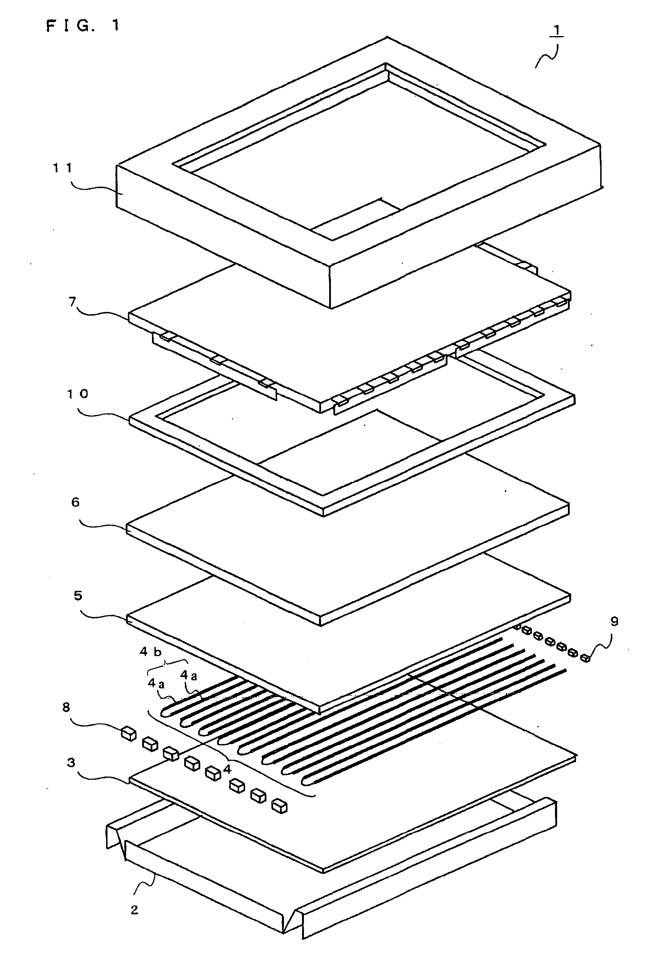

[First Embodiment]
Fig. 1 is an exploded perspective view to show structure of a liquid crystal module according to a first embodiment. With reference to Fig. 1, total structure of the liquid crystal module 1 according to the first embodiment will be explained. The liquid crystal module 1 according to the first embodiment is provided with a rear frame 2, a reflection sheet 3, a back light source 4, a diffusion plate 5, an optical sheet 6, and a liquid crystal cell 7.

The rear frame 2 is formed from metal and it has structure in that the reflection sheet 3 and the back light source 4 can be housed. The reflection sheet 3 is formed of a white synthetic resin plate having insulating property, which is put on the rear frame 2. The reflection sheet 3 is included to reflect light which is emitted from the back light source 4.

The back light source 4 is composed of a plurality of line light sources 4a which are gathered together. In the liquid crystal module 1 according to the first embodiment as shown in Fig. 1, there are sixteen pieces of the line light sources 4a. To be more concrete, these line light sources 4a are made of cold cathode fluorescent lamps (CCFLs), and two line light sources 4a are combined to form one of the CCFLs 4b in the liquid crystal module 1. That is, by connecting each one end of the two line light sources 4a, one of the CCFLs 4b having U shape is composed.

One end sides of this U shaped CCFLs 4b are supported by lamp holders 8 which are made of an elastic member such as silicon rubber. Further, the other end sides of the CCFLs are inserted in lamp sockets 9 and the CCFLs 4b are connected to an inverter circuit which is not shown in the drawing through the lamp sockets 9. Driving of such U shaped CCFLs 4b is performed by applying AC voltage on both ends of the CCFLs 4b such that respective ends become inversed phase each other.

The diffusion plate 5 has a function to diffuse light which is emitted from the back light source 4 and is input directly, and light which is emitted from the back light source 4 and is input after it is reflected by the reflection sheet 3. Further, in the optical sheet 6 a diffusing sheet which diffuses light is included, and diffusion of light is also performed there to achieve correction of uneven brightness and the like. It should be noted that the diffusion plate 5 and the optical sheet 6 are in a state where they are held down to the rear frame 2 by a cell guide 10.

The liquid crystal cell 7 is disposed on upper side of the optical sheet 6. The liquid crystal cell 7 has well known structure that it is provided with a pair of polarizing filters, a pair of glass substrates which are set up between the pair of polarizing filters, a liquid crystal, a transparent electrode, a color filter, and the like which are set up between the glass substrates. The liquid crystal cell 7 is in a state where it is regulated its position by the cell guide 10 and fixed by a bezel 11.

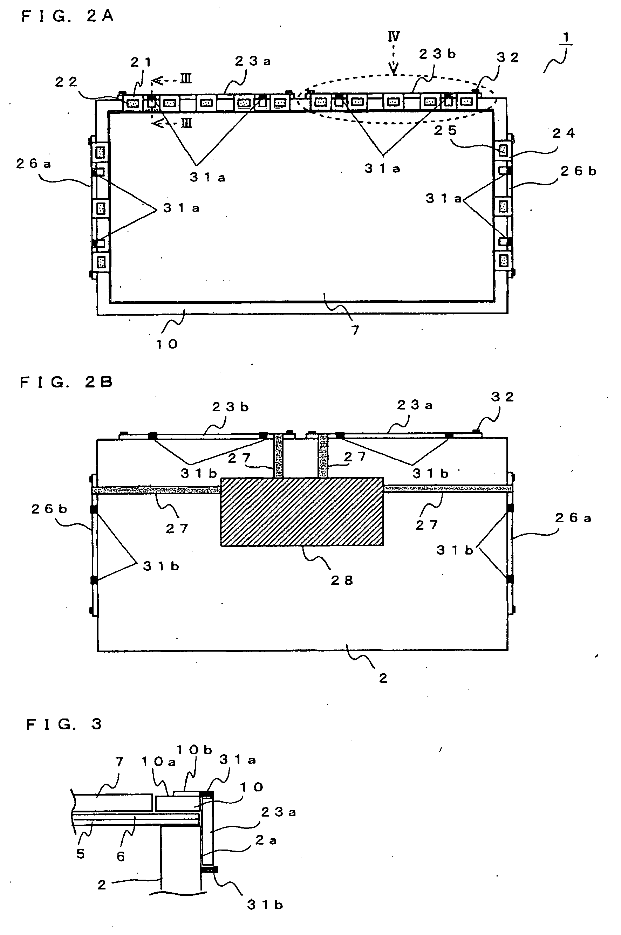

Next, explanation will be given about positional relation of the plurality of circuit boards which are set up to drive the liquid crystal cell 7 with reference to Fig. 2. It should be noted that Fig. 2A and Fig. 2B are explanatory diagrams to explain the positional relation of the plurality of circuit boards which are set up to drive the liquid crystal cell 7, Fig. 2A is a schematic plan view of the liquid crystal module 1 according to the first embodiment when it is viewed from a front side (side on which the display surface is set up) and Fig. 2B is a schematic plan view of the liquid crystal module 1 according to the first embodiment when it is viewed from a reverse side. It should be noted that in Fig. 2A and Fig. 2B states where the bezel 11 (See, Fig. 1) is not attached, are shown for the sake of convenience of explanation.

As shown in Fig. 2A and Fig. 2B, one ends of ten pieces of flexible circuit boards 21 are joined along a side of longer side (a side in upper side in Fig. 2A and Fig. 2B) in the outer peripheral portion of the liquid crystal cell 7 which is set up in substantially rectangular shape. Joining of the liquid crystal cell 7 and the flexible circuit boards 21 is performed utilizing, for example, an anisotropic conductive film (ACF). According to this arrangement an electrode (not shown) which is set up on the liquid crystal cell 7 and the flexible circuit boards 21 are electrically connected.

Further, one ends of three pieces of flexible circuit boards 24 are joined along both shorter sides of the outer peripheral portions of the liquid crystal cell 7. Joining of the liquid crystal cell 7 and the flexible circuit boards 24 is performed utilizing, for example, the ACF. According to this arrangement an electrode (not shown) which is set up on the liquid crystal cell 7 and the flexible circuit boards 24 are electrically connected.

Source drivers 22 to give signal to a source of a thin film transistor (TFT, not shown) which is set up on a glass substrate of the liquid crystal cell 7, are connected by, for example, chip on film (COF) method to each of the flexible circuit boards 21 which are joined to the liquid crystal cell 7. Further, gate drivers 25 to give signal to a gate of the thin film transistor are connected by, for example, the COF method to each of the flexible circuit boards 24 which are joined to the liquid crystal cell 7.

Though connection of the source drivers 22 or the gate drivers 25 to the flexible circuit boards 21, 24, is performed by the COF method in the present embodiment, it should be noted that the present invention is not intended to be limited to the embodiment, tape career package (TCP) method, for example, may be employed to connect.

Among the flexible circuit boards 21 which are joined to the liquid crystal cell 7, one ends of five flexible circuit boards 21 which are in a left half side thereof are connected to a left source relay board 23a, and one ends of five flexible circuit boards 21 which are in a right half side thereof are connected to a right source relay board 23b by soldering, for example. Further, among the flexible circuit boards 24 which are joined to the liquid crystal cell 7, one ends of the flexible circuit boards 24 which are joined to left side of the liquid crystal cell 7 are connected to the gate relay board 26a, and one ends of the flexible circuit boards 24 which are joined to right side thereof are connected to the gate relay board 26b by soldering, for example.

Though one source relay board and one gate relay board are disposed in the conventional structure shown in Fig. 7, it should be noted that two of them are disposed in the present embodiment. Because the liquid crystal module according to the first embodiment is for large scale liquid crystal module (for example, it is used in 37 inch liquid crystal television), length of the relay board becomes long. If one source relay board and one gate relay board are used as well as the conventional one, it causes a problem that usability becomes worse or the like. Therefore, each of them is divided in two. That is, number of the relay boards which are included in the liquid crystal module is properly changed because of its size and the like.

As shown in Fig. 2B, a controller board 28 on which a control circuit that controls the source drivers 22 and the gate drivers 25 is loaded, is attached on the surface which is opposite side of the rear frame 2 from the side on which the liquid crystal cell 7 is disposed. The controller board 28 is electrically connected to the source relay boards 23a, 23b and the gate relay boards 26a, 26b by connecting members 27 which are composed of flat cable and the like. That is, the source relay boards 23a, 23b play a role to relay the flexible circuit boards 21 on which the source drivers 22 are loaded, and the controller board 28. And the gate relay boards 26a, 26b play a role to relay the flexible circuit boards 24 on which the gate drivers 25 are loaded, and the controller board 28.

The source relay boards 23a, 23b and the gate relay boards 26a, 26b are fixed on the rear frame 2 utilizing screws 32. As a result, the liquid crystal module 1 according to the present embodiment is structured such that the relay boards 23a, 23b, 26a, 26b are not rotated by applying force in a rotating direction even when the screws 32 to fix the relay boards 23a, 23b, 26a, 26b are fastened or loosened.

Hereinafter, explanation will be given about structure to prevent the rotation of the relay boards 23a, 23b, 26a, 26b along with the rotation of the screws 32 with reference to Fig. 2A, Fig. 2B, and Fig. 3. It should be noted that Fig. 3 is a schematic cross sectional view when cut along III-III line in Fig. 2A.

As shown in Fig. 2A on the cell guide 10, a plurality of protruding portions 31a which protrude from the cell guide 10 toward outside (reverse side of the side on which the liquid crystal cell 7 is set up), are set up. Explanation will be given about structure of the protruding portions 31a with reference to Fig. 3. It should be noted that the structure of the plurality of protruding portions 31a set up, is quite the same as the structure shown in Fig. 3 for every protruding portion 31a.

As shown in Fig. 3, the protruding portions 31a protrude toward outside from step portions 10b which protrude from an upper surface 10a of the cell guide 10. Further, the protruding portions 31a are made to protrude to the source relay board 23a side with regard to a surface 2a on which the source relay board 23a of the rear frame 2 is attached by screw fastening. In the present embodiment the protruding portions 31a are formed integrally with the cell guide 10 which is made of resin. However, the present invention is not intended to be limited to the embodiment, and the protruding portions 31a may be formed by attaching another member on the cell guide 10 or the like. Further in the present embodiment, amount of protrusion of the protruding portions 31a is made substantially equal to thickness of the source relay board 23a which is formed in a flat plate. However, the present invention is not intended to be limited to the embodiment, it can be adequately changed.

Now back to Fig. 2A, positions of the plurality of protruding portions 31a which are set up on the cell guide 10, are along the side surface of the longer side of the respective relay boards 23a, 23b, 26a, 26b which are set up in substantially rectangular flat plate shape. Further, in the present embodiment, each of the protruding portions 31a is formed on a position corresponding to each end side of the respective relay boards 23a, 23b, 26a, 26b. That is, two protruding portions 31a are formed along the respective relay boards 23a, 23b, 26a, 26b, a total of eight protruding portions 31a are formed on the cell guide 10.

Though, the protruding portions 31a protrude from a position which is higher than the upper surface 10a of the cell guide 10 (See, Fig. 3) in the present embodiment, it should be noted that the present invention is not intended to be limited to the embodiment. That is, the protruding portions 31a may protrude from a side surface of the cell guide 10 according to positional relation between the cell guide 10 and the relay board 23a.

Further, as shown in Fig. 2B and Fig. 3, a plurality of protruding portions 31b which protrude to the relay board side with regard to the surface 2a of the rear frame 2 on which the relay board (any one of the source relay boards 23a, 23b and the gate relay boards 26a, 26b) is attached by screw fastening, are set up on the rear frame 2. For any one of the plurality of protruding portions 31b set up, the position of respective protruding portions 31b is a opposite position of the relay board (any one of the source relay boards 23a, 23b and the gate relay boards 26a, 26b) from the protruding portions 31a as shown in Fig. 3. That is, eight protruding portions 31b are formed as much as the protruding portions 31a. It should be noted that, in the present embodiment, amount of protrusion of the protruding portions 31b is made substantially equal to the thickness of the relay boards 23a, 23b, 26a, 26b which are formed in the flat plate. However, the present invention is not intended to be limited to the embodiment, it can be adequately changed.

In the present embodiment the protruding portions 31b are formed integrally with the rear frame 2 by bending a part of the rear frame 2 which is made from metal. However, the present invention is not intended to be limited to the embodiment, the protruding portions 31b may be formed by attaching another member on the rear frame 2 or the like, for example.

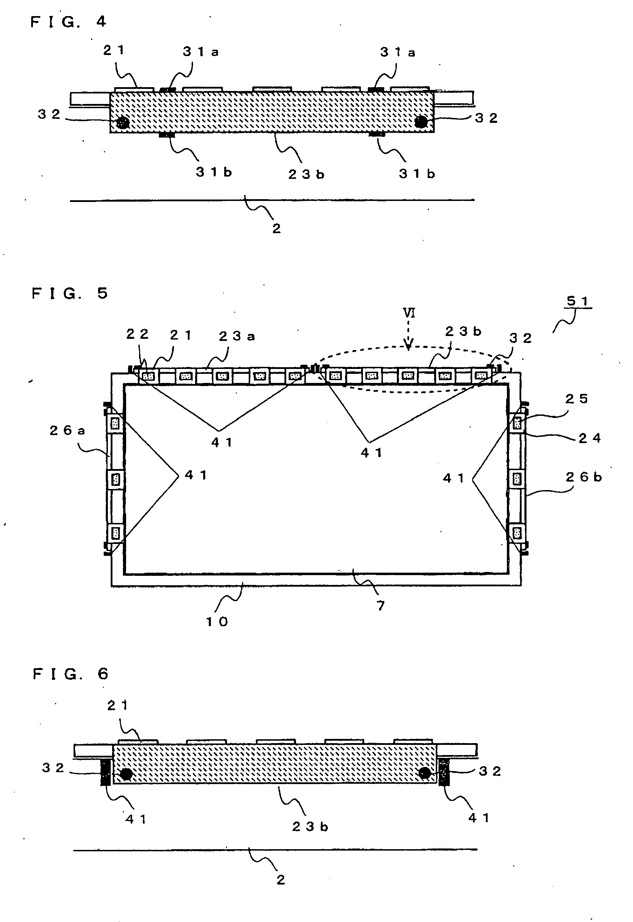

Explanation will be given about an action of the protruding portions 31a, 31b which are formed as above described to prevent the relay boards 23a, 23b, 26a, 26b from rotating, when the relay boards 23a, 23b, 26a, 26b are fixed by the screws 32, or when the fastened screws 32 are loosened, with reference to Fig. 4. It should be noted that Fig. 4 is a schematic plan view of a portion which is surrounded by dotted ellipse in Fig. 2A when viewed from position IV. Further in the present embodiment, the explanation will be given about the source relay board 23b as an example, however, the situation is quite the same as the source relay board 23a, and the gate relay boards 26a, 26b.

In Fig. 4, if the right side screw 32 is fastened at first between two screw fastening portions, force to rotate the source relay board 23b in clockwise is generated utilizing the screw fastening portion (right side) as a supporting point. Even when such force is applied, the rotation of the source relay board 23b is prevented by contact of the source relay board 23b and the protruding portion 31a. On the other hand, if the left side screw 32 is fastened at first, force to rotate the source relay board 23b in clockwise is generated utilizing the screw fastening portion (left side) as the supporting point. Even when such force is applied, the rotation of the source relay board 23b is prevented by contact of the source relay board 23b and the protruding portion 31b.

On the other hand, in case where the right side screw 32 is loosened later between the two screw fastening portions, force to rotate the source relay board 23b in counter clockwise is generated utilizing the screw fastening portion (right side) as a supporting point. Even when such force is applied, the rotation of the source relay board 23b is prevented by contact of the source relay board 23b and the protruding portion 31b. On the other hand, in case where the left side screw 32 is loosened later, force to rotate the source relay board 23b in counter clockwise is generated utilizing the screw fastening portion (left side) as the supporting point. Even when such force is applied, the rotation of the source relay board 23b is prevented by contact of the source relay board 23b and the protruding portion 31a.

It should be noted that, of course the protruding portions 31a, 31b are in a state where they are beforehand contacting with the source relay board 23b when the screw fastening is performed and the like, or they are disposed nearby the source relay board 23b in order that they can prevent the rotation of the source relay board 23b in a level that the flexible circuit boards 21 do not have damage even though the protruding portions 31a, 31b do not contact with the relay board 23b.

In the present embodiment shown above, two protruding portions 31a (or 31b) are formed along one side surface of longer side of the respective relay boards 23a, 23b, 26a, 26b that are set up in substantially rectangular plate shape, however, the present invention is not intended to be limited to the embodiment. That is, for example, one protruding portion 31a (or 31b) may be set up near central portion of one side surface of longer side, or three or more protruding portions 31a (or 31b) may be formed.

Further in the present embodiment, the protruding portions 31a and the protruding portions 31b which are set up along the side surface of the longer side of the respective relay boards 23a, 23b, 26a, 26b, are disposed in opposing positions each other. However, the present invention is not intended to be limited to the embodiment. The protruding portions 31a and the protruding portions 31b which are set up along the side surface of the longer side of the respective relay boards 23a, 23b, 26a, 26b, may not be disposed in opposing positions but in shifted positions.

Further in the present embodiment, the protruding portions 31a and the protruding portions 31b are set up such that they sandwich the respective relay boards 23a, 23b, 26a, 26b. However in case where, for example, order to fasten or to loosen the screws is decided, and moving directions of the end portion of the relay boards 23a, 23b, 26a, 26b are decided when the screws are fastened or loosened (upper side or lower side in Fig. 4), the protruding portions may be set up along only one side surface of the longer side of the relay boards 23a, 23b, 26a, 26b which are set in substantially rectangular flat plate shape, (for example, only the protruding portions 31a or the protruding portions 31b are set up).

Further in the present embodiment, the protruding portions 31a and the protruding portions 31b which are set up along the side surface of the longer side of the relay boards 23a, 23b, 26a, 26b, are respectively formed on the cell guide 10 and the rear frame 2. However the present invention is not intended to be limited to the embodiment. That is, it is possible to structure them such that the protruding portions which are set up along the both sides of the longer side of the relay board, are set up only on the rear frame 2, for example in response to whole structure of the liquid crystal module 1 Or the protruding portions may be set up on member which is different from the cell guide 10 and the rear frame 2.

[Second Embodiment] Next, explanation will be given about a liquid crystal module according to a second embodiment. The liquid crystal module according to the second embodiment has different structure to prevent rotation of the relay board when fastening or loosening of the screws is performed in comparison with the liquid crystal module 1 according to the first embodiment, however, other structures are as same as the liquid crystal module 1 according to the first embodiment. Therefore, portions which are common to the first embodiment are referred to with the same reference numerals and explanation for them will be omitted if not necessary.

Fig. 5 is a schematic plan view of a liquid crystal module 51 according to the second embodiment when viewed from a front side, it shows a state where bezel 11 (See, Fig. 1) is not attached for the sake of convenience of explanation. Fig. 6 is a schematic plan view of a portion which is surrounded by dotted ellipse in Fig. 5 when viewed from position VI. Hereinafter, explanation will be given about structure and action which are included in the liquid crystal module 51 according to the second embodiment to prevent the rotation of relay boards 23a, 23b, 26a, 26b with reference to Fig. 5 and Fig. 6.

Though Fig. 6 is a diagram to show periphery of the source relay board 23b, it should be noted that structure of periphery is quite the same as that of the source relay board 23a, and the gate relay boards 26a, 26b. Therefore, the explanation has a same meaning even when the source relay board 23b is replaced to any of the source relay board 23a, and the gate relay boards 26a, 26b in the explanation below. As a result, the explanation below will be given only about a case for the source relay board 23b, and other will be omitted.

In the second embodiment, the protruding portions 41 are formed such that they protrude to the source relay board 23b side with regard to a surface on which the source relay board 23b of the rear frame 2 is attached by screw fastening. Further, the protruding portions 41 are disposed along both side surfaces of shorter side of the source relay board 23b which is set up substantially rectangular plate shape, and are set up to sandwich the source relay board 23b. Further, amount of protrusion of the protruding portions 41 is made substantially equal to thickness of the source relay board 23b which is formed in a flat plate.

In the present embodiment, the protruding portions 41 are formed integrally with the rear frame 2 by bending a part of the rear frame 2 which is made from metal. However, the present invention is not intended to be limited to the embodiment, so the protruding portions 41 may be formed by attaching another member on the rear frame 2 or the like, for example.

By structuring as above described, even if force to rotate the source relay board 23b is applied when the screws 32 are fastened or loosened, the rotation of the source relay board 23b can be prevented by contact of the protruding portions 41 and the source relay board 23b. It should be noted that the protruding portions 41 are naturally in a state where it is beforehand contacting with the source relay board 23b when the screw fastening is performed and the like, or it is disposed nearby the source relay board 23b in order that it can prevent the rotation of the source relay board 23b in a level that the flexible circuit boards 21 do not have damage even though it does not contact with the relay board 23b.

In the present embodiment, the protruding portions 41 which are set up along the both sides of the shorter side of the respective relay boards 23a, 23b, 26a, 26b, are formed on the rear frame 2. However, the present invention is not intended to be limited to the embodiment. For example, the protruding portions 41 may be set up on different member from the rear frame 2.

Further in the present embodiment, a total of eight protruding portions 41 are set up such that they sandwich the respective relay boards 23a, 23b, 26a, 26b. However, with reference to Fig. 5 because the source relay board 23a and the source relay board 23b are disposed side by side, the protruding portion 41 which is disposed in right side of the source relay board 23a and the protruding portion 41 which is disposed in left side of the source relay board 23b may not be formed separately and be combined into one protruding portion.

[Others] The above described embodiments show structure in which rotation of the relay boards 23a, 23b, 26a, 26b which simply relay the flexible circuit boards 21, 24 to the controller board 28 with the rotation of the screw when the screw is fastened or loosened, is prevented. However, range where the present invention can be applied is not intended to be limited to it. That is, there is a case that a circuit board on which circuit elements are loaded and which has function that is different from mere relay board, is disposed on the position where the relay boards 23a, 23b, 26a, 26b is disposed, and the present invention can be applied to such case, too.

According to the liquid crystal module in accordance with the present invention, possibility of damage of a flexible circuit board which is joined to an outer peripheral portion of a liquid crystal cell when a liquid crystal module is assembled or disassembled, can be reduced. As a result, the present invention is useful in a field of the liquid crystal module.

Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

## Claims

1. A liquid crystal module, comprising:
a liquid crystal cell (7);
a flexible circuit board (21, 24) which is joined to an outer peripheral portion of the liquid crystal cell (7); and
a circuit board (23a, 23b, 26a, 26b) which is set up in substantially rectangular plate shape and which is joined to the flexible circuit board (21, 24);
a frame portion on which the circuit board (23a, 23b, 26a, 26b) is fixed by screw fastening; and
a plurality of protruding portions (31a) which protrude to the circuit board (23a, 23b, 26a, 26b) side with regard to a surface of the frame portion (2) on which the circuit board (23a, 23b, 26a, 26b) is attached, **characterized by** the protruding portions being set up along both side surfaces of longer side of the circuit board (23a, 23b, 26,a, 26b) such that the plurality of protruding portions (31a) sandwich the circuit board (23a, 23b, 26a, 26b).

2. The liquid crystal module according to claim 1, further comprising a guide portion (10) which surrounds the liquid crystal cell (7) so as to perform positioning of the liquid crystal cell (7), **characterized in that** the plurality of protruding portions (31 a) are formed on at least one of the guide portion (10) and the frame portion (2).

3. The liquid crystal module according to claim 2, **characterized in that** the at least one protruding portion (31a) is formed integrally with the guide portion (10) or the frame portion (2).

4. The liquid crystal module according to anyone of claim 1 to claim 3,
**characterized in that**
on the flexible circuit board (21, 24) a driver element (22, 25) to drive the liquid crystal cell (7) is loaded, and
the liquid crystal module further comprises a controller board (28) on which a control circuit to control the driver element (22, 25) is loaded, and the circuit board (1) is a relay board to relay the flexible circuit board (21, 24) and the controller board (28).

## Patentansprüche

1. Flüssigkristallmodul mit:
einer Flüssigkristallzelle (7);
einer elastischen Schaltkarte (21, 24), die mit einen Außenumfangsbereich der Flüssigkristallzelle (7) verbunden ist; und
einer Schaltkarte (23a, 23b, 26a, 26b), die in im Wesentlichen rechteckiger Kartenform eingebaut und mit der elastischen Schaltkarte (21, 24) verbunden ist;
einem Rahmenbereich, auf welchem die Schaltkarte (23a, 23b, 26a, 26b) durch Schraubverbindung befestigt ist; und
mehreren vorstehenden Bereichen (31a), die zur Seite der Schaltkarte (23a, 23b, 26a, 26b) in Bezug auf eine Oberfläche des Rahmenbereichs (2) vorstehen, auf welcher die Schaltkarte (23a, 23b, 26a, 26b) angebracht ist, **dadurch gekennzeichnet, dass** die vorstehenden Bereiche entlang beiden Seitenflächen der längeren Seite der Schaltkarte (23a, 23b, 26a, 26b) so eingebaut sind, dass die mehreren vorstehenden Bereiche (31a) die Schaltkarte (23a, 23b, 26a, 26b) sandwichartig umschließen.

2. Flüssigkristallmodul nach Anspruch 1, ferner mit einem Führungsbereich (10), der die Flüssigkristallzelle (7) so umgibt, dass er die Positionierung der Flüssigkristallzelle (7) durchführt, **dadurch gekennzeichnet, dass** die mehreren vorstehenden Bereiche (31a) auf dem Führungsbereich (10) und/oder dem Rahmenbereich (2) ausgebildet sind.

3. Flüssigkristallmodul nach Anspruch 2, **dadurch gekennzeichnet, dass** der zumindest eine vorstehende Bereich (31a) einstückig mit dem Führungsbereich (10) oder dem Rahmenbereich ausgebildet ist.

4. Flüssigkristallmodul nach irgendeinem von Anspruch 1 bis Anspruch 3,
**dadurch gekennzeichnet, dass**
auf der elastischen Schaltkarte (21, 24) ein Treiberelement (22, 25) zum Ansteuern der Flüssigkristallzelle (7) geladen ist, und
das Flüssigkristallmodul ferner eine Steuerungskarte (28) umfasst, auf welcher eine Steuerschaltung zum Steuern des Treiberelements (22, 25) geladen ist, und die Schaltkarte (11) eine Relaiskarte zum Verbinden der elastischen Schaltkarte (21, 24) und der Steuerungskarte (28) ist.

## Revendications

1. Module à cristaux liquides, comprenant :
une cellule à cristaux liquides (7) ;
une carte de circuits flexible (21, 24) qui est jointe à une partie périphérique extérieure de la cellule à cristaux liquides (7) ; et
une carte de circuits (23a, 23b, 26a, 26b) qui est définie à une forme de plaque sensiblement rectangulaire et qui est jointe à la carte de circuits flexible (21, 24) ;
une partie de cadre sur laquelle la carte de circuits (23a, 23b, 26a, 26b) est fixée par une fixation à vis ; et
une pluralité de parties (31a) en saillie qui font saillie vers le côté de carte de circuits (23a, 23b, 26a, 26b) par rapport à une surface de la partie (2) de cadre sur laquelle la carte de circuits (23a, 23b, 26a, 26b) est fixée, **caractérisé par** les parties en saillie étant disposées le long des deux surfaces latérales du côté le plus long de la carte de circuits (23a, 23b, 26a, 26b) de telle sorte que la pluralité de parties (31a) en saillie prennent en sandwich la carte de circuits (23a, 23b, 26a, 26b).

2. Module à cristaux liquides selon la revendication 1, comprenant en outre une partie (10) de guide qui entoure la cellule à cristaux liquides (7) de façon à effectuer un positionnement de la cellule à cristaux liquides (7), **caractérisé en ce que** la pluralité de parties (31a) en saillie sont formées sur au moins une parmi la partie (10) de guide et la partie (2) de cadre.

3. Module à cristaux liquides selon la revendication 2, **caractérisé en ce que** l'au moins une partie (31a) en saillie est formée de façon intégrale avec la partie (10) de guide ou la partie (2) de cadre.

4. Module à cristaux liquides selon l'une quelconque de la revendication 1 à la revendication 3, **caractérisé en ce que** sur la carte de circuits flexible (21, 24), un élément (22, 25) de pilotage pour piloter la cellule à cristaux liquides (7) est chargé, et
le module à cristaux liquides comprend en outre une carte de contrôleur (28) sur laquelle un circuit de commande pour commander l'élément (22, 25) de pilotage est chargé, et la carte de circuits (1) est une carte relais pour relayer la carte de circuits flexible (21, 24) et la carte de contrôleur (28).
